Europäisches Patentamt

European Patent Office

Office européen des brevets

(11) Veröffentlichungsnummer: **0 442 407 A1**

# EUROPÄISCHE PATENTANMELDUNG

(21) Anmeldenummer: 91101857.0

(22) Anmeldetag: **11.02.91**

(51) Int. Cl.5: **H01F 10/14**

(30) Priorität: **13.02.90 DE 4004304**
**29.08.90 DE 4027226**

(43) Veröffentlichungstag der Anmeldung:
**21.08.91 Patentblatt 91/34**

(84) Benannte Vertragsstaaten:
**AT BE CH DE FR GB IT LI NL SE**

(71) Anmelder: **Forschungszentrum Jülich GmbH**
**Postfach 1913, Wilhelm-Johnen-Strasse**
**W-5170 Jülich(DE)**

(72) Erfinder: **Grünberg, Peter, Dr.**
**Einsteinstrasse 34**
**W-5170 Jülich(DE)**
Erfinder: **Schreiber, Reinert**
**Heinrichsallee 1**
**W-5180 Eschweiler(DE)**
Erfinder: **Vohl, Michael**
**Bahlenstrasse 181**
**W-4000 Düsseldorf 13(DE)**

(54) **Magnetfeldsensor mit ferromagnetischer, dünner Schicht.**

(57) Die Erfindung betrifft einen Magnetfeldsensor mit ferromagnetischer dünner Schicht zum Auslesen magnetisch gespeicherter Daten. Dieser Magnetfeldsensor weist wenigstens zwei durch eine Zwischenschicht getrennte ferromagnetische Schichten auf, die aus Materialien bestehen, die eine antiparallele Einstellung der Magnetisierungrichtungen der beiden ferromagnetischen Schichten bewirken. Aufgabe der Erfindung ist es, einen Magnetfeldsensor mit anderen als den bisher bekannten Materialkombinationen zu schaffen. Zur Lösung dieser Aufgabe ist eine Zwischenschicht aus Kupfer oder einer Legierung auf der Basis von Kupfer vorgesehen. Die Dicke dieser Zwischenschicht liegt im Bereich zwischen 0,4 - 10 nm.

FIG. 1

EP 0 442 407 A1

## MAGNETFELDSENSOR MIT FERROMAGNETISCHER, DÜNNER SCHICHT

Die Erfindung bezieht sich auf einen Magnetfeldsensor mit ferromagnetischer dünner Schicht und zugehörigen Strom- und Spannungskontakten zum Auslesen magnetisch gespeicherter Daten, bei dem wenigstens zwei durch eine Zwischenschicht (C) getrennte ferromagnetische Schichten (A,B) vorgesehen sind, die aus Materialien bestehen, die bewirken, daß entweder ohne oder unter Mitwirkung eines äußeren Magnetfeldes die Magnetisierungsrichtung der beiden ferromagnetischen Schichten in einer Komponente antiparallel stehen.

Magnetfeldsensoren aus dünnen magnetischen Filmen, die von einem Strom I durchflossen werden und bei deren Einsatz der Magnetowiderstandseffekt ausgenutzt wird, sind bekannt (s. DE-PS 38 20 475). Das Anwendungsgebiet dieser Magnetfeldsensoren ist in erster Linie das Auslesen magnetisch gespeicherter Daten (z.B. Festplatte, Floppy-Disk, Magnetbänder usw.), aber auch alle Anwendungen, bei denen es auf den Nachweis von Magnetfeldern mit hoher Ortsauflösung ankommt.

Es ist Aufgabe der Erfindung, einen Magnetfeldsensor mit anderen als den bisher bekannten Materialkombinationen zu schaffen.

Die der Erfindung zugrundeliegende Aufgabe wird durch einen Magnetfeldsensor mit den kennzeichnenden Merkmalen des Anspruchs 1 gelöst. Es zeigte sich in unerwarteter Weise, daß bei Verwendung von Cu und Legierungen auf der Basis von Cu als Zwischenschicht (C) mit einer Zwischenschichtdicke ab einer Dicke von 0.4 nm, vorzugsweise einer Dicke von 0.4 bis 10 mm, ein merklich größerer Widerstandseffekt als bei Au, Cr und V gemessen wurde. Alle in dieser Schrift angegebenen Schichtdicken wurden während der Präparation mit einem Schwingquarz-Dickenmeßgerät bestimmt.

Desweiteren liegt der Materialpreis von Cu wesentlich niedriger als bei den magnetowiderstandsaktiven Materialien wie Au und Ru. Cu und Legierungen auf der Basis von Cu bieten daher den Vorteil eines großen Magnetowiderstandseffektes bei günstigen Materialpreis.

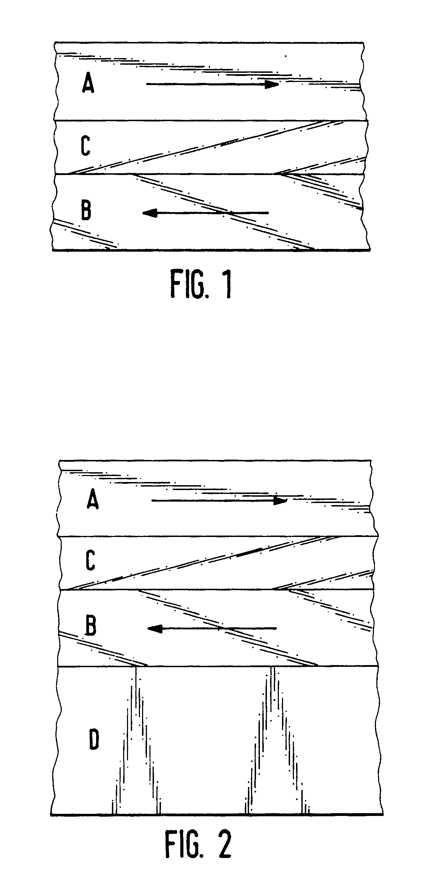

Bei einer ersten Ausführungsart des Magnetfeldsensors sind die die ferromagnetischen Schichten (A,B), wie in Fig. 1 ersichtlich, aus Materialien mit unterschiedlichen Koerzitivfeldstärken $H_c$ vorgesehen. Die beiden ferromagnetischen Schichten sind dabei durch eine Zwischenschicht aus Cu oder einer Legierung auf der Basis von Cu entkoppelt. Die antiparallele Ausrichtung der Magnetisierung der Schichten wird in diesem Falle beim Durchlaufen der Magnetisierungskurve der geschichteten Struktur für bestimmte Werte eines äußeren Magnetfeldes B erreicht. Als Materialien mit großem $H_c$ sind zweckmäßigerweise für die eine ferromagnetische Schicht hartmagnetische Legierungen von Fe, Co, Ni usw., und als Material mit kleinem $H_c$ für die andere ferromagnetische Schicht weichmagnetische Legierungen, z.B. Permalloy, vorgesehen.

Bei einer weiteren Ausführungsart des Magnetfeldsensors gemäß der Erfindung sind durch Cu oder eine Legierung auf der Basis von Cu getrennte ferromagnetische Schichten vorgesehen, wobei an einer der ferromagnetischen Schichten (A,B) eine weitere Schicht (D), wie in Fig. 2 ersichtlich, aus antiferromagnetischen Material anliegt. Bei dieser Ausführungsart des Magnetfeldsensors wird durch Ausnutzen der sog. Austauschanisotropie, die an der Grenzfläche zwischen einen Ferro und einem Antiferromagneten auftreten kann und die zu einer Verschiebung der Hysteresekurve an der der antiferromagnetischen Schicht anliegenden ferromagnetischen Schicht führt, die antiparallele Ausrichtung der Magnetisierungen der ferromagnetischen Schichten erreicht.

Das antiferromagnetische Material der zusätzlichen Schicht (D) kann beispielsweise MnFe sein. Aber auch andere antiferromagnetische Materialien wie beispielsweise CoO sind anwendbar.

Eine weitere, vorteilhafte Ausführungsform des Magnetfeldsensors weist mindestens eine epitaktische Co-Schicht mit kubisch flächenzentrierter (kfz) Struktur auf. Dadurch laufen durch die magnetiche Anisotropie der Schicht während der Ummagnetisierung Drehprozesse zwischen zueinander senkrechten Richtungen ab. Dann kommt zu dem oben erwähnten Magnetowiderstandseffekt durch antiparallele Ausrichtung noch der übliche anisotrope Magnetowiderstandseffekt, und es ergibt sich eine weitere Erhöhung des Signals.

Selbstverständlich können die Merkmale der verschiedenen Ausführungsarten in einem Magnetfeldsensor kombiniert sein.

Figurenbeschreibung

Figur 1    Querschnitt durch eine Schichtanordnung mit durch eine Zwischenschicht C getrennten ferromagnetischen Schichten A,B

Figur 2    Querschnitt durch eine Schichtanordnung mit zusätzlicher antiferromagnetischer Schicht D

**Patentansprüche**

1.   Magnetfeldsensor mit ferromagnetischer dünner Schicht und zugehörigen Strom- und Spannungskontakten zum Auslesen magnetisch gespeicherter Daten, bei dem wenigstens zwei durch eine Zwischenschicht (C) getrennte ferromagnetische Schichten (A,B) vorgesehen sind, die aus Materialien bestehen, die bewirken, daß entweder ohne oder unter Mitwirkung eines äußeren Magnetfeldes die Magnetisierungsrichtung der beiden ferromagnetischen Schichten in einer Komponente antiparallel stehen,
**dadurch gekennzeichnet,**
daß für die Zwischenschicht (C) Cu oder eine Legierung auf der Basis von Cu vorgesehen ist.

2. Magnetfeldsensor nach Anspruch 1,
**dadurch gekennzeichnet,**
daß die Zwischenschicht eine Dicke von 0,4 bis 10 mm aufweist.

3. Magnetfeldsensor nach Anspruch 1 oder 2,
**dadurch gekennzeichnet,**
daß für die ferromagnetischen Schichten (A,B) Materialien mit unterschiedlichen Koerzitivfeldstärken $H_c$ vorgesehen sind.

4. Magnetfeldsensor nach einem der Ansprüche 1 bis 3,
**dadurch gekennzeichnet,**
daß eine zusätzliche Schicht (D) aus antiferromagnetischem Material vorgesehen ist, die an einer der beiden ferromagnetischen Schichten anliegt.

5. Magnetfeldsensor nach einem der Ansprüche 1 bis 4,
**dadurch gekennzeichnet,**
daß mindestens eine epitaktische Co-Schicht mit kubisch flächenzentrierter (kfz) Struktur vorgesehen ist.

FIG. 1

FIG. 2

## EINSCHLÄGIGE DOKUMENTE

EP 91101857.0

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| D,A | DE - C1 - 3 820 475<br>(KERNFORSCHUNGSANLAGE JÜLICH)<br>  * Zusammenfassung; Patentansprüche 1-12; Fig. 1-5 *<br>-- | 1-5 | H 01 F 10/14 |
| A | DE - A1 - 3 810 244<br>(HITACHI)<br>  * Zusammenfassung; Patentansprüche 1-5; Fig. 2 *<br>-- | 1-5 | |
| A | JP - A -63-288 411<br>(SANGO)<br>  * Zusammenfassung; Fig. 1-7 *<br>-- | 1-5 | |
| A | JP - A -61-84 572<br>(TDK)<br>  * Zusammenfassung; Fig. 2 *<br>---- | 1-5 | |

RECHERCHIERTE SACHGEBIETE (Int Cl⁵)

H 01 F 10/00
H 01 F  1/00

Der vorliegende Recherchenbericht wurde für alle Patentansprüche erstellt.

| Recherchenort | Abschlußdatum der Recherche | Prüfer |
|---|---|---|
| WIEN | 25-04-1991 | VAKIL |